(19) Europäisches Patentamt
European Patent Office
Office européen des brevets

(11) **EP 3 742 312 A1**

(12) **EUROPEAN PATENT APPLICATION**
published in accordance with Art. 153(4) EPC

(43) Date of publication:
**25.11.2020 Bulletin 2020/48**

(51) Int Cl.:
***G06F 17/50*** *(2006.01)*

(21) Application number: **18874996.4**

(22) Date of filing: **14.11.2018**

(86) International application number:
**PCT/CN2018/115446**

(87) International publication number:
**WO 2019/140995 (25.07.2019 Gazette 2019/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **17.01.2018 CN 201810045295**

(71) Applicant: **BOE TECHNOLOGY GROUP CO., LTD. Beijing 100015 (CN)**

(72) Inventor: **XIU, Liming**
**BDA Beijing 100176 (CN)**

(74) Representative: **Brötz, Helmut et al**
**Rieder & Partner mbB**
**Patentanwälte - Rechtsanwalt**
**Corneliusstrasse 45**
**42329 Wuppertal (DE)**

(54) **MACHINE ENTROPY CALCULATION METHOD AND CIRCUIT, AND METHOD AND ELECTRONIC SYSTEM FOR IMPLEMENTING TIME COGNITION**

(57) A calculation method of a machine entropy, a calculation circuit of a machine entropy, a method for implementing time cognition, and an electronic system for implementing time cognition are disclosed. The calculation method of a machine entropy includes: monitoring electrical signals of the electronic system (S102); and calculating the machine entropy, the machine entropy being a sum of change times of characteristic parameters of the electrical signals (S104).

100

S102

monitoring electrical signals of the electronic system

S104

calculating the machine entropy, the machine entropy being a sum of change times of characteristic parameters of the electrical signals

FIG. 1

## Description

CROSS-REFERENCE TO RELATED APPLICATION

The present application claims priority of Chinese Patent Application No. 201810045295.2, filed on January 17, 2018, the disclosure of which is incorporated herein by reference in its entirety as part of the present application.

TECHNICAL FIELD

The embodiments of the present disclosure relate to a calculation method of a machine entropy, a calculation circuit of a machine entropy, a method for implementing time cognition, and an electronic system for implementing time cognition.

BACKGROUND

The study of artificial intelligence begins with a desire to simulate a human brain with a computer. At present, there are two method, a first method of the two method is functional simulation, and a second method of the two method is structural simulation. In the functional simulation, a robotic brain is regarded as a black box. A structure and a material of the black box are not related to research, and the black box only needs to simulate a function of the human brain. For example, machine learning, deep learning, convolutional neural networks, deep relief networks and so on are all related to the functional simulation. Through learning, the robotic brain can continuously accumulate knowledge and learn strategies from a experience of solving a certain kind of problem, so that when the robotic brain encounters similar problems later, the robotic brain can use the accumulated experience to solve the similar problems. While in the study of structural simulation, the robotic brain is no longer regarded as a black box, but it is expected that a brain-like robotic brain can be created by imitating the human brain's physical structure, and consciousness and thoughts are generated in this brain-like robotic brain.

People expect to generate consciousness and thoughts in the robotic brain, because there are many problems in real life that cannot be solved by current artificial intelligence technology. The current artificial intelligence technology is only good at solving certain kinds of specific problems. On many other issues related to subjective judgment, it is far inferior to human beings. A mode of solving a problem by human beings is usually to make a quickest and intuitive judgment, rather than a way of step-by-step derivation and calculation generally used by artificial intelligence. In other words, the artificial intelligence cannot be only limited to logical thinking, but also needs to learn image thinking. An obstacle between the logical thinking and the image thinking is consciousness and thoughts. The most primitive element of consciousness is time consciousness.

SUMMARY

An embodiment of the present disclosure provides a calculation method of a machine entropy for an electronic system, comprising: monitoring electrical signals of the electronic system; and calculating the machine entropy, the machine entropy being a sum of change times of characteristic parameters of the electrical signals.

For example, in the calculation method of the machine entropy provided by an embodiment of the present disclosure, the electrical signals comprise all electrical signals in the electronic system, and the machine entropy is a sum of change times of characteristic parameters of the all electrical signals.

For example, in the calculation method of the machine entropy provided by an embodiment of the present disclosure, the electrical signals comprise electrical signals, corresponding to a proportion that is not less than a certain predetermined proportion, in the electronic system.

For example, in the calculation method of the machine entropy provided by an embodiment of the present disclosure, the machine entropy is directly proportional to a total amount of information processed by the electronic system, to a wear degree of the electronic system, and to a total amount of energy consumed by the electronic system.

For example, in the calculation method of the machine entropy provided by an embodiment of the present disclosure, for each of the electrical signals, a case where a change value of an amplitude of a characteristic parameter of each of the electrical signals meets a predetermined threshold range indicates that a change in the characteristic parameter has occurred one time.

For example, in the calculation method of the machine entropy provided by an embodiment of the present disclosure, a case where the amplitude of the characteristic parameter rises from a first threshold to a second threshold or drops from the second threshold to the first threshold indicates that the change in the characteristic parameter has occurred one time.

For example, in the calculation method of the machine entropy provided by an embodiment of the present disclosure, the characteristic parameters of the electrical signals comprise at least one of voltages of the electrical signals or currents of the electrical signals.

An embodiment of the present disclosure provides a method for implementing time cognition in an electronic system, comprising: calculating a machine entropy in the electronic system, which comprises: monitoring electrical signals in the electronic system, and calculating the machine entropy, the machine entropy being a sum of change times of characteristic parameters of the electrical signals; and indicating a direction of time movement by using a direction in which the machine entropy changes.

For example, in the method for implementing time cognition provided by an embodiment of the present disclosure, each value of the machine entropy represents a moment on a timeline.

For example, in the method for implementing time cognition provided by an embodiment of the present disclosure, a direction in which the machine entropy increases represents a direction in which time moves forward.

For example, in the method for implementing time cognition provided by an embodiment of the present disclosure, a current value of the machine entropy represents "present", based on the current value, a direction in which the machine entropy decreases represents "past", and a direction in which the machine entropy increases represents "future".

For example, in the method for implementing time cognition provided by an embodiment of the present disclosure, the electrical signals comprise all electrical signals in the electronic system, and the machine entropy is a sum of change times of characteristic parameters of the all electrical signals.

For example, in the method for implementing time cognition provided by an embodiment of the present disclosure, the electrical signals comprise electrical signals, corresponding to a proportion that is not less than a certain predetermined proportion, in the electronic system.

For example, in the method for implementing time cognition provided by an embodiment of the present disclosure, the machine entropy is directly proportional to a total amount of information processed by the electronic system, to a wear degree of the electronic system, and to a total amount of energy consumed by the electronic system.

For example, in the method for implementing time cognition provided by an embodiment of the present disclosure, for each of the electrical signals, a case where a change value of an amplitude of a characteristic parameter of each of the electrical signals meets a predetermined threshold range indicates that a change in the characteristic parameter has occurred one time.

For example, in the method for implementing time cognition provided by an embodiment of the present disclosure, for each of the electrical signals, a case where the amplitude of the characteristic parameter of each of the electrical signals rises from a first threshold to a second threshold or drops from the second threshold to the first threshold indicates that the change in the characteristic parameter has occurred one time.

For example, in the method for implementing time cognition provided by an embodiment of the present disclosure, the characteristic parameters of the electrical signals comprises at least one of voltages of the electrical signals or currents of the electrical signals.

An embodiment of the present disclosure further provides a calculation circuit of a machine entropy, comprising: a monitoring sub-circuit, configured to monitor electrical signals in an electronic system; and a calculation sub-circuit, configured to calculate the machine entropy, the machine entropy being a sum of change times of characteristic parameters of the electrical signals.

For example, in the calculation circuit of the machine entropy provided by an embodiment of the present disclosure, the electrical signals comprise all electrical signals in the electronic system, and the machine entropy is a sum of change times of characteristic parameters of the all electrical signals.

For example, in the calculation circuit of the machine entropy provided by an embodiment of the present disclosure, the electrical signals comprise electrical signals, corresponding to a proportion that is not less than a certain predetermined proportion, in the electronic system.

For example, in the calculation circuit of the machine entropy provided by an embodiment of the present disclosure, the machine entropy is directly proportional to a total amount of information processed by the electronic system, to a wear degree of the electronic system, and to a total amount of energy consumed by the electronic system.

For example, in the calculation circuit of the machine entropy provided by an embodiment of the present disclosure, for each of the electrical signals, a case where a change value of an amplitude of a characteristic parameter of each of the electrical signals meets a predetermined threshold range indicates that a change in the characteristic parameter has occurred one time.

For example, in the calculation circuit of the machine entropy provided by an embodiment of the present disclosure, the amplitude of the characteristic parameter rises from a first threshold to a second threshold or drops from the second threshold to the first threshold indicates that the change in the characteristic parameter has occurred one time.

An embodiment of the present disclosure further provides an electronic system for implementing time cognition, comprising: the calculation circuit of the machine entropy according to any one of the above embodiments; and a time indicating circuit, configured to indicate a direction of time movement by using a direction in which the machine entropy changes.

For example, in the electronic system provided by an embodiment of the present disclosure, each value of the machine entropy represents a moment on a timeline.

For example, in the electronic system provided by an embodiment of the present disclosure, a direction in which the machine entropy increases represents a direction in which time moves forward.

For example, in the electronic system provided by an embodiment of the present disclosure, a space cognition circuit, configured to achieve space cognition of the electronic system; a clock generation circuit, configured to generate a clock signal to establish an operating order of the electronic system; and a timing circuit, configured to measure or control a length of an event occurring within the electronic system, in which the length is calibrated by using the clock signal.

BRIEF DESCRIPTION OF THE DRAWINGS

In order to clearly illustrate the technical solutions of the embodiments of the disclosure, the drawings of the embodiments will be briefly described in the following; it is obvious that the described drawings are only related to some embodiments of the disclosure and thus are not limitative to the disclosure. Based on the described drawings herein, those skilled in the art can obtain other drawing(s), without any inventive work.

FIG. 1 is a flowchart of a calculation method of a machine entropy provided by an embodiment of the present disclosure;
FIG. 2 is a flowchart of a method for implementing time cognition in an electronic system provided by an embodiment of the present disclosure;
Fig. 3A shows a schematic diagram of an exemplary relationship between change of entropy in a generalized system and time movement;
FIG. 3B shows a schematic diagram of an exemplary relationship between change of machine entropy in an electronic system and time movement;
FIG. 4 is a schematic block diagram of a calculation circuit of a machine entropy provided by an embodiment of the present disclosure;
Fig. 5A is a first schematic block diagram of an electronic system provided by an embodiment of the present disclosure; and
FIG. 5B is a second schematic block diagram of an electronic system provided by an embodiment of the present disclosure.

DETAILED DESCRIPTION

In order to make objects, technical details and advantages of the embodiments of the disclosure apparent, the technical solutions of the embodiments will be described in a clearly and fully understandable way in connection with the drawings related to the embodiments of the disclosure. Apparently, the described embodiments are just a part but not all of the embodiments of the disclosure. Based on the described embodiments herein, those skilled in the art can obtain other embodiment(s), without any inventive work, which should be within the scope of the disclosure.

Consciousness and thought activity in the human brain may be based on three basic cognitive objects, i.e. number, space and time. For example, in the expression "the weather is very hot today", "today" is a time factor, "weather" contains both a spatial factor and a numerical factor, the spatial factor is such as an environment where the temperature is sensed, and regarding the numerical factor, for example, the number on a thermometer may be used to represent the degree of "hot". For a robot brain, it can sense numbers by nature, and the reason is that the computer itself is made up of discrete elements and components. With aid of a variety of sensors, the robot brain can also sense space. However, the robot brain has a natural obstacle to sense time. In nature, no physical mechanism has been found that can be used to design time sensors by far. Among known physical phenomena, only the half-life of radioactive elements, sediments in geological structure, annual rings of trees, and the life and death of organisms can indirectly reflect the flow of time, but none of them are suitable for sensor design. Therefore, generating the concept of time in the robot brain is much more difficult than making the robot brain recognize numbers and space.

In terms of cognitive time, three aspects, that is, sensing time, manufacturing time and measuring time, need to be distinguished. "Manufacturing time" means that a time device is manufactured and used to arrange the order of operations, and for example, a clock, and a crystal oscillator circuit in a semiconductor chip, etc. "Measuring time" means that a time device is used to calibrate other events. For example, a stopwatch may be used to calibrate the free-fall motion of an iron ball (grid lines through which a stopwatch pointer has passed on the stopwatch during a process in which the iron ball falls from the top of a tower to the ground). While "sensing time" requires that the time device directly sense the time, and the time device itself senses the flow of time without any external device. A watch in life is not the time that people senses in the true sense, and a clock pulse generated by the crystal oscillator circuit is not the time that the robot brain senses in the true sense. For example, because of autonomy consciousness, people can also be aware of the "past", "present" and "future" of time without the aid of any timing devices such as watches and clocks.

The essence of time is change. From a physics perspective, let us look at a relationship among change, energy and time. In the 19th century, along with the emergence of steam engines, thermodynamics has gradually become a science. Thermodynamics is a science about system. The system may be a machine, our earth, or the entire universe. What described by the first law of thermodynamics is that, the energy in a closed system is conserved. The second law of thermodynamics describes the conversion of energy. When one job is completed, it is accompanied by conversion of energy from one form to another form or several other forms. In this energy conversion, efficiency will never be 100%. In a steam engine, a part of the energy from coal combustion is converted into useful kinetic energy, and another part of the energy from coal combustion is converted into useless heat. This useless energy consumption represents a change from order to disorder. This is an irreversible process. The concept of entropy is used to describe the degree of this disorder, and a value of the entropy is used to describe a direction of this irreversibility. Therefore, there is an inherent consistency between entropy and time, and a change direction of the entropy is a direction of time.

When energy changes from one form to another form or several other forms, entropy increases and time also goes by in this process, along with the loss of energy (loss of energy →entropy is increasing →time is passing).

Computers complete specific works by converting electric energies into directional motion of electrons. In this process, a part of the electric energies is wasted instead of being used to do useful work (such as electric energies consumed by random motion of electrons). These wasted energies increase entropy. This increase in entropy is the direction of time movement, and it may be used to guide the robot brain to produce consciousness of time. Based on this, embodiments of the present disclosure proposes a concept of machine entropy (EM), so that an electronic system can know the increase of entropy and calculate a value of the entropy.

Electrical signals in an electronic system have a high-low variation in magnitude of voltage amplitude, and this high-low variation in magnitude represents information, and denotes that a useful work has been done. At the same time, a change in the amplitude of each electrical signal is accompanied by a loss of energy (the second law of thermodynamics states that efficiency will never be 100 percent), and is also accompanied by an increment of entropy. Therefore, a sum of change times of voltage or current of an electrical signal has a direct-proportion relationship with the increment of entropy (for example, the sum of all change times of voltages of all the electrical signals or the sum of all change times of currents of all the electrical signals has a direct-proportion relationship with the increment of entropy). Therefore, the change in voltage and/or current of an electrical signal can reflect the change in entropy, and can be used to indicate the movement of time.

How to produce a sense of time in machines has been researched in the present disclosure. Embodiments of the present disclosure provide a calculation method of a machine entropy, a calculation circuit of a machine entropy, a method for implementing time cognition, and an electronic system for implementing time cognition, in which the machine entropy can be used to establish a sense of time in the electronic system, thereby providing a framework of time-space cognition for further development of artificial intelligence.

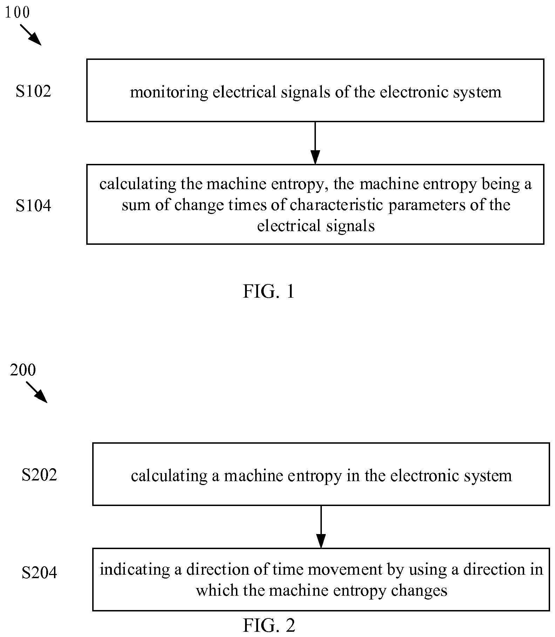

FIG. 1 is a flowchart illustrating a calculation method of a machine entropy provided by an embodiment of the present disclosure. For example, as shown in FIG. 1, an embodiment of the present disclosure provides the calculation method of the machine entropy 100 for an electronic system, which includes, but is not limited to:

step S102: monitoring electrical signals of the electronic system; and
step S104: calculating the machine entropy, the machine entropy being a sum of change times of characteristic parameters of the electrical signals.

For example, the electrical signals include, but are not limited to, a control signal, a data signal, an address signal, and an electric signal of other types in the electronic system. The present disclosure does not limit the types of electrical signals. The characteristic parameters of the electrical signals include at least one of voltages or currents of the electrical signals. The present disclosure does not limit the types of characteristic parameters of electrical signals.

For example, in some embodiments, the electrical signals include all the electrical signals in the electronic system, and the machine entropy is a sum of change times of characteristic parameters of all the electrical signals (e.g., the cumulative sum of the number of times of changes, that have been occurred so far, in the characteristic parameters). For example, the machine entropy is the cumulative sum of the number of times of all voltage changes, that have been occurred so far, of all the electrical signals; alternatively, the machine entropy is the cumulative sum of the number of times of all current changes, that have been occurred so far, of all the electrical signals; alternatively, the machine entropy is the cumulative sum of the number of times of all voltage changes, that have been occurred so far, of all the electrical signals and the number of times of all current changes, that have been occurred so far, of all the electrical signals. In some embodiments, the electrical signals include electrical signals, corresponding to a proportion that is not less than a certain predetermined proportion, in the electronic system. For example, the electrical signals include at least 80%, 90%, 95%, 99% (or other proportional value) of all the electrical signals of the electronic system (i.e., a part of all the electrical signals), and the machine entropy is the sum of change times of characteristic parameters of these electrical signals. For example, the machine entropy may be the cumulative sum of the number of times of all voltage changes, that have been occurred so far, of these partial electrical signals; or the machine entropy may be the cumulative sum of the number of times of all current changes, that have been occurred so far, of these partial electrical signals; or, the machine entropy may be the cumulative sum of the number of times of all voltage changes, that have been occurred so far, of these partial electrical signals and the number of times of all current changes, that have been occurred so far, of these partial electrical signals. The present disclosure does not limit the number of electrical signals to be monitored here, as long as the machine entropy can be qualitatively computed.

For example, the machine entropy ME of the electronic system may be expressed as follows:

$$ME = \sum_{i=1}^{N} S(F_i)$$

where, $F_i$ denotes a characteristic parameter of the i-th electrical signal, i=1, 2, 3, ... N, N denotes the total number of electrical signals, and $S(F_i)$ denotes the number of times of changes, that have been occurred so far, in the characteristic parameter of the i-th electrical signal.

For example, in some embodiments, for each monitored electrical signal, a case where a change value $\Delta F$ of an amplitude of a characteristic parameter satisfies a predetermined threshold range (e.g., $\Delta F \geq$ a predetermined threshold) indicates that a change in the characteristic parameter of the monitored the electric signal has been occurred one time. For example, a case where an amplitude of a characteristic parameter of an electrical signal rises from a first threshold FSS to a second threshold FDD or drops from the second threshold FDD to the first threshold FSS indicates that change in the characteristic parameter of the electrical signal has been occurred one time. For another example, the predetermined threshold is an absolute value of a difference among the first threshold FSS, the second threshold FDD and a controllable parameter $\delta$, that is, the predetermined threshold $=|FDD - FSS - \delta|$; a case where $\Delta F \geq | FDD - FSS - \delta|$ indicates that the change in the characteristic parameter of the electric signal has been occurred one time.

For example, the first threshold FSS, the second threshold FDD, and the predetermined threshold may be pre-determined based on relevant factors such as an ambient environment surrounding the electronic system, a degree of electromagnetic interference, a level of internal noise, a data processing capacity, etc., so that the first threshold FSS, the second threshold FDD, and the predetermined threshold are used for accurately judging whether a voltage of an electric signal has changed or not. For example, a higher predetermined threshold may be set for an electronic system with a high noise level, and a lower predetermined threshold may be set for an electronic system with a low noise level. The setting of the predetermined threshold can reduce the noise interference when the change of a characteristic parameter is judged.

For example, when the characteristic parameter is a voltage, the machine entropy ME of the electronic system may be expressed as follows:

$$ME = \sum_{i=1}^{N} S(V_i)$$

where, $V_i$ denotes the voltage of the i-th electrical signal, and $S(V_i)$ denotes the number of times of changes, that have been occurred so far, in the voltage of the i-th electrical signal. For the i-th electrical signal, every time the voltage of the i-th electrical signal changes, the value of $S(V_i)$ is incremented by one automatically.

In this case (namely, when the characteristic parameter is the voltage), the change value $\Delta F$ of the amplitude of the characteristic parameter is a change

value $\Delta V$ of the voltage amplitude, the predetermined threshold is a predetermined voltage difference threshold, the first threshold FSS is a first voltage threshold VSS, and the second threshold FDD is a second voltage threshold VDD. For each monitored electrical signal, a case where the change value $\Delta V$ of the voltage amplitude meets a predetermined threshold range (e. g., $\Delta V \geq$ a predetermined voltage difference threshold) indicates that a change in the voltage of the electrical signal has been occurred one time. For example, a case where the voltage amplitude of an electrical signal rises from the first voltage threshold VSS to the second voltage threshold VDD or drops from the second voltage threshold VDD to the first voltage threshold VSS indicates that a change in the voltage of the electrical signal has been occurred one time. For another example, the predetermined voltage difference threshold is an absolute value of a difference among the first voltage threshold VSS, the second voltage threshold VDD, and a controllable parameter $\delta$, that is, the predetermined voltage difference threshold = $|VDD - VSS - \delta|$; when $\Delta V \geq |VDD - VSS - \delta|$, it is calculated as one voltage change of the electrical signal.

For another example, when the characteristic parameter is a current, the machine entropy ME of the electronic system may be expressed as follows:

$$ME = \sum_{i=1}^{N} S(I_i)$$

where, $I_i$ denotes the current of the i-th electrical signal, and $S(I_i)$ denotes the number of times of changes, that have been occurred so far, in the current of the i-th electrical signal. For the i-th electrical signal, every time the current of the i-th electrical signal changes, the value of $S(I_i)$ is incremented by one automatically.

In this case (namely, when the characteristic parameter is the current), the change value $\Delta F$ of the amplitude of the characteristic parameter is a change value $\Delta I$ of the current amplitude, the predetermined threshold is a predetermined current difference threshold, the first threshold FSS is a first current threshold ISS, and the second threshold FDD is a second current threshold IDD. For each monitored electrical signal, a case where the change value $\Delta I$ of the current amplitude meets a predetermined threshold range (e. g., $\Delta I \geq$ a predetermined current difference threshold) indicates that a change in the current of the electrical signal has been occurred one time. For example, a case where the current amplitude of an electrical signal rises from the first current threshold ISS to the second current threshold IDD or drops from the second current threshold IDD to the first current threshold ISS indicates that a change in the current of the electrical signal has been occurred one time. For another example, the predetermined current difference threshold is an absolute value of a difference among the first current threshold ISS, the second current threshold IDD, and a controllable parameter $\delta$, that is, the pre-

determined current difference threshold = |*IDD* - *ISS* - δ|; a case where Δ*I* ≥ | *IDD* - *ISS* - δ| indicates that the change in the current of the electrical signal has been occurred one time.

For another example, when the characteristic parameter includes a voltage and a current, the machine entropy ME of the electronic system may be expressed as follows:

$$ME = \sum_{i=1}^{N} S(I_i) + S(V_i)$$

where, $V_i$ denotes the voltage of the i-th electrical signal, $S(V_i)$ denotes the number of times of changes, that have been occurred so far, in the voltage of the i-th electrical signal, $I_i$ denotes the current of the i-th electrical signal, and $S(I_i)$ denotes the number of times of changes, that have been occurred so far, in the current of the i-th electrical signal. For the i-th electrical signal, every time the current of the i-th electrical signal changes, the value of $S(I_i)$ is incremented by one automatically, and every time the voltage of the i-th electrical signal changes, the value of $S(V_i)$ is incremented by one automatically.

In the embodiments of the present disclosure, time is not used in the definition of characteristic parameters (e.g., $V_i$ and $I_i$) of each electrical signal. In the past, the voltage or the current of a signal was defined in time, such as V(t) or I(t), while here, time is not used to define characteristic parameters of a signal. The reason is that, cognition of time is one of objectives intended to be achieved by technical schemes of embodiments of the present disclosure. In an embodiment of the present disclosure, the value of machine entropy is the sum of change times of characteristic parameters of electrical signals, and it is a continuously cumulative calculation process. Each change in voltage or current is accompanied by a certain amount of energy loss, and an increment of the machine entropy. Thus, the machine entropy defined in the embodiments of the present disclosure is consistent with the entropy in thermodynamics in terms of direction.

The information entropy defined in Shannon's information theory is also intrinsically consistent with the machine entropy of the embodiments of the present disclosure. In the information theory, the value of information entropy is directly proportional to the size of total amount of information. In machine entropy, the sum of change times of characteristic parameters of electrical signals is directly proportional to the amount of information processed by the electronic system. Therefore, the value of machine entropy also represents the total amount of information processed by the electronic system, and the total amount of information increases synchronously with time.

In an electronic system, the basic and widespread change is the consumption of quantity of electricity, and meanwhile the change also expresses the wear and tear of the life of the electronic system and the total amount of information processed by the electronic system. The change is an irreversible process, indicating the direction of time. Machine entropy provides a "time sensor" to the electronic system by means of computability of numerical value, so as to make the electronic system pay attention to the consumption of its own energy and the wear and tear of the life, which is equivalent to the awakening of the electronic system to the sense of time.

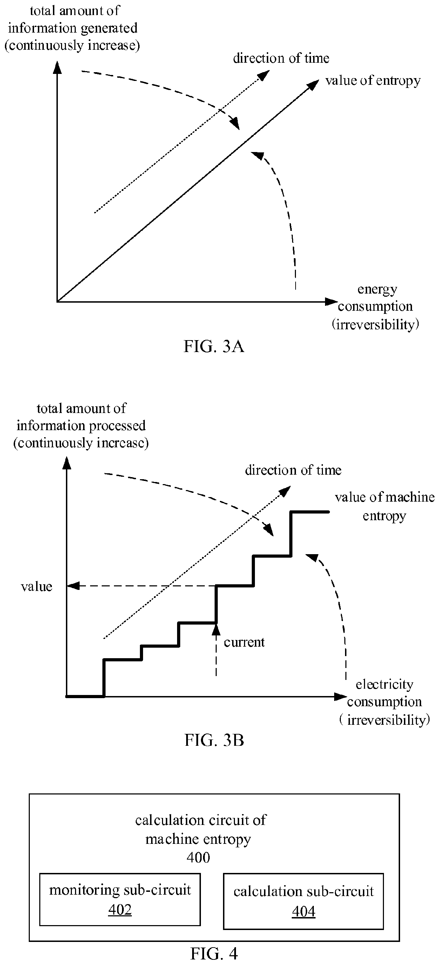

Fig. 3A shows the calculation of entropy in a generalized system. The entropy in the generalized system is directly proportional to the total amount of information processed by the system, to the wear degree of the system, and to the total amount of energy consumed by the system. The direction in which the entropy increases indicates the direction in which time moves forward. FIG. 3B shows the calculation of machine entropy in an electronic system provided by an embodiment of the present disclosure. The machine entropy is directly proportional to a total amount of information processed by the electronic system, to a wear degree of the electronic system, and to a total amount of energy consumed by the electronic system. Each value of the machine entropy represents a current (now), representing a moment on the timeline.

An embodiment of the present disclosure also provides a method 200 for implementing time cognition in an electronic system. FIG. 2 is a flowchart illustrating a method for implementing time cognition in an electronic system provided by an embodiment of the present disclosure. A sense of time can be produced in the electronic system by the method 200. As shown in FIG. 2, the method 200 includes, but is not limited to:

step S202, calculating a machine entropy in the electronic system; and
step S204, indicating a direction of time movement by using a direction in which the machine entropy changes.

For example, in step S202, calculating a machine entropy in the electronic system includes: monitoring electrical signals in the electronic system; and calculating the machine entropy, the machine entropy being the sum of change times of characteristic parameters of the electrical signals. Regarding the specific description of step S202, reference may be made to the calculation method 100 of the machine entropy shown in FIG. 1, and the present disclosure is not repeated herein again.

For example, each value of the machine entropy represents a moment on the timeline.

For example, a direction in which the machine entropy increases represents a direction in which time moves forward.

For example, a current value of the machine entropy represents "present"; based on the current value, a direction in which the machine entropy decreases represents "past", and a direction in which the machine entropy increases represents "future".

For example, the electrical signals include all the electrical signals in the electronic system, and the machine entropy is a sum of change times of characteristic parameters of all the electrical signals. For another example, the electrical signals include electrical signals, corresponding to a proportion that is not less than a certain predetermined proportion, in the electronic system, and the machine entropy is the sum of change times of characteristic parameters of these electrical signals. It is to be noted that, regarding the detailed description of the electrical signals, reference may be made to the relevant description of the electrical signals in the above embodiments of the calculation method of the machine entropy.

For example, the machine entropy is directly proportional to a total amount of information processed by the electronic system, to a wear degree of the electronic system, and to a total amount of energy consumed by the electronic system.

For example, for each of the electrical signals, a case where a change value of an amplitude of a characteristic parameter meets a predetermined threshold range indicates that a change in the characteristic parameter has occurred one time. For example, for each of the electrical signals, a case where the amplitude of the characteristic parameter rises from a first threshold to a second threshold or drops from the second threshold to the first threshold indicates that the change in the characteristic parameter has occurred one time.

For example, the characteristic parameters of the electrical signals include at least one of voltages of the electrical signals or currents of the electrical signals.

FIG. 4 is a schematic block diagram illustrating a calculation circuit of a machine entropy provided by an embodiment of the present disclosure. As shown in FIG. 4, an embodiment of the present disclosure further provides a calculation circuit 400 of a machine entropy, which includes a monitoring sub-circuit 402 configured to monitor electrical signals in an electronic system; and a calculation sub-circuit 404 configured to calculate the machine entropy, the machine entropy being a sum of change times of characteristic parameters of the electrical signals.

For example, the electrical signals include all the electrical signals in the electronic system, and the machine entropy is the sum of change times of the characteristic parameters of all the electrical signals. For another example, the electrical signals include electrical signals, corresponding to a proportion that is not less than a predetermined proportion, in the electronic system, and the machine entropy is the sum of change times of the characteristic parameters of these electrical signals.

For example, the machine entropy is directly proportional to the total amount of information processed by the electronic system, to the wear degree of the electronic system, and to the total amount of energy consumed by the electronic system.

For example, for each of the electrical signals, a case where a change value of the amplitude of the characteristic parameter meets a predetermined threshold range indicates that a change in the characteristic parameter has occurred one time. For example, a case where the amplitude of the characteristic parameter rises from a first threshold to a second threshold or drops from the second threshold to the first threshold indicates that the change in the characteristic parameter has occurred one time.

For example, both the monitoring sub-circuit 402 and the calculation sub-circuit 404 are dedicated circuits, and may be designed to be separate chips, respectively, or integrated into the same chip. For example, both the monitoring sub-circuit 402 and the calculation sub-circuit 404 may be implemented with transistors or FPGA (or ASIC), and the present disclosure does not limit this here.

Regarding the specific description of the calculation circuit 400 of the machine entropy, reference may be made to the above calculation method 100 of the machine entropy shown in FIG. 1, and the present disclosure is not repeated herein again.

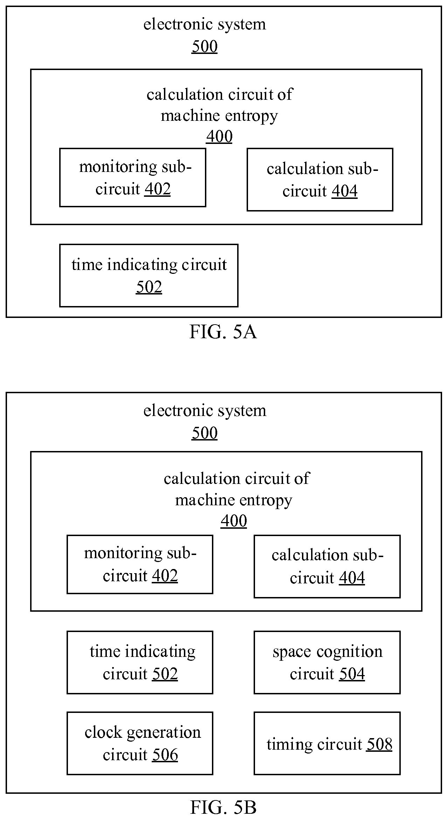

Fig. 5A is A first schematic block diagram illustrating an electronic system provided by an embodiment of the present disclosure; and FIG. 5B is a second schematic block diagram illustrating an electronic system provided by an embodiment of the present disclosure. As shown in FIGS. 5A and 5B, an embodiment of the present disclosure further provides an electronic system 500 for implementing time cognition, including a calculation circuit 400 of a machine entropy; and a time indicating circuit 502 configured to indicate a direction of time movement by using a direction in which the machine entropy changes.

For example, each value of the machine entropy represents a moment on the timeline.

For example, a direction in which the machine entropy increases represents a direction in which time moves forward.

For example, the time indicating circuit 502 is a dedicated circuit, which may be designed as a separate chip or integrated with the calculation circuit 400 of the machine entropy into the same chip. For example, the time indicating circuit 502 may be implemented with transistors or FPGA (or ASIC), and the present disclosure does not limit this here.

For example, as shown in FIG. 5B, the electronic system 500 further includes a space cognition circuit 504 configured to achieve space cognition of the electronic system; a clock generation circuit 506 configured to generate a clock signal to establish an operating order of the electronic system; and a timing circuit 508 configured to measure or control a length of an event occurring within the electronic system, the length being calibrated by using the clock signal.

For example, the space cognition circuit 504 includes a sensor circuit, which may be used to determine a spatial position where the electronic system is located. For example, the space cognition circuit 504 includes a gyroscope, a global positioning system (GPS), a radar, a depth camera, etc.

For example, the clock generation circuit 506 includes a crystal oscillator circuit that can generate a clock pulse.

For example, the timing circuit 508 includes a counter configured to measure or control the length of the event taking place in the electronic system, based on the number of pulses of the clock signal. For example, the timing circuit 508 includes an integrated counter chip or a programmable counter chip.

The electronic system shown in FIG. 5B may sense time with aid of the calculation circuit 400 of the machine entropy and a time indicating circuit 502, create time with aid of the clock generation circuit 506 so as to establish order, and measure time with aid of a timing circuit 508. The electronic system provided by an embodiment of the present disclosure not only can establish a sense of space, but also can establish a sense of time, thereby constructing a framework for the future robotic brain chip.

In an embodiment of the present disclosure, the calculation circuit 400 of the machine entropy (including a monitoring sub-circuit 402 and a calculation sub-circuit 404) and the time indicating circuit 502 may be implemented with dedicated hardware (e.g. a dedicated chip, an integrated circuit, etc.).

Of course, the functions of the calculation circuit 400 of the machine entropy (including a monitoring sub-circuit 402 and a calculation sub-circuit 404) and the time indicating circuit 502 may also be implemented by means of a combination of software and hardware. The present disclosure does not limit this. For example, the electronic system (including the calculation circuit 400 of the machine entropy, the time indicating circuit 502 and other circuits in FIG. 5B) can be a circuit board or a combination of a plurality of circuit boards. The circuit board or a combination of the plurality of circuit boards may include: (1) one or more processors; (2) one or more non-transitory computer-readable memories connected with the processors; and (3) processor-executable firmware stored in the memories.

The processor may process data signals and may include various computing architectures such as a complex instruction set computer (CISC) architecture, a reduced instruction set computer (RISC) architecture or an architecture for implementing a combination of multiple instruction sets. In some embodiments, the processor can be a microprocessor, such as an X86 processor or an ARM processor, or can be a digital signal processor (DSP) and the like. The processor can control other components in the electronic system to perform the desired functions.

The memory may store instructions and/or data executed by the processor. The memory may comprise one or more computer program products. The computer program products may comprise various forms of computer-readable storage media, such as volatile memory and/or non-volatile memory. The volatile memory may comprise, for example, a random access memory (RAM) and/or a cache or the like. The non-volatile memory may comprise, for example, a read only memory (ROM), a hard disk, a flash memory, and the like. One or more computer program instructions may be stored on the computer-readable storage medium and the processor may execute the program instructions to implement desired functions such as machine entropy calculation, time cognition and the like. Various applications, various data used and/or generated by the applications, and the like, may also be stored in the computer-readable storage medium.

An embodiment of the present disclosure further provides a computer readable storage medium. Computer instructions are stored on the computer readable storage medium. When the computer instructions are executed by a processor, the operations of the method 100 as shown in FIG. 1 and the method shown in FIG. 2 are performed. For example, the above memory is one of the computer readable storage medium.

To sum up, an embodiment of the present disclosure provides a calculation method of a machine entropy, a calculation circuit of a machine entropy, a method for implementing time cognition and an electronic system for implementing time cognition, in which the machine entropy can be used to establish a sense of time in the electronic system, thereby providing a framework of time-space cognition for the further development of artificial intelligence.

In the present disclosure, relational terms such as first and second are used merely to distinguish one entity or operation from another entity or operation, and do not necessarily require or imply any such actual relationship or order between these entities or operations. Moreover, the terms "comprise", "include" or any other variation thereof are intended to encompass a non-exclusive inclusion, such that a process, a method, an item or a device that comprises a plurality of elements includes not only those elements but also includes other elements that are not explicitly listed, or includes elements that are inherent to such process, method, item or device. Without further limitations, an element defined by the phrase "comprising a ..." does not exclude the existence of additional identical elements in the process, method, item or device including the element.

Obviously, various changes and modifications can be made by the skilled in the art to the present disclosure, without departing from the spirits and the scope of the present disclosure. Therefore, so far as these changes and modifications fall in the scope of the claims and their equivalents of the present disclosure, the present disclosure shall also intend to cover such changes and modifications.

What have been described above are only specific implementations of the present disclosure, the protection scope of the present disclosure is not limited thereto. Any changes or substitutions easily occur to those skilled in the art within the technical scope of the present disclosure should be covered in the protection scope of the present disclosure. Therefore, the protection scope of the present disclosure should be based on the protection scope of the claims.

**Claims**

1. A calculation method of a machine entropy for an electronic system, comprising:

    monitoring electrical signals of the electronic system; and
    calculating the machine entropy, the machine entropy being a sum of change times of characteristic parameters of the electrical signals.

2. The calculation method of the machine entropy according to claim 1, wherein the electrical signals comprise all electrical signals in the electronic system, and the machine entropy is a sum of change times of characteristic parameters of the all electrical signals.

3. The calculation method of the machine entropy according to claim 1, wherein the electrical signals comprise electrical signals, corresponding to a proportion that is not less than a certain predetermined proportion, in the electronic system.

4. The calculation method of the machine entropy according to any one of claims 1 to 3, wherein the machine entropy is directly proportional to a total amount of information processed by the electronic system, to a wear degree of the electronic system, and to a total amount of energy consumed by the electronic system.

5. The calculation method of the machine entropy according to any one of claims 1 to 4, wherein for each of the electrical signals, a case where a change value of an amplitude of a characteristic parameter of each of the electrical signals meets a predetermined threshold range indicates that a change in the characteristic parameter has occurred one time.

6. The calculation method of the machine entropy according to claim 5, wherein a case where the amplitude of the characteristic parameter rises from a first threshold to a second threshold or drops from the second threshold to the first threshold indicates that the change in the characteristic parameter has occurred one time.

7. The calculation method of the machine entropy according to any one of claims 1 to 6, wherein the characteristic parameters of the electrical signals comprise at least one of voltages of the electrical signals or currents of the electrical signals.

8. A method for implementing time cognition in an electronic system, comprising:

    calculating a machine entropy in the electronic system, which comprises: monitoring electrical signals in the electronic system, and calculating the machine entropy, the machine entropy being a sum of change times of characteristic parameters of the electrical signals; and
    indicating a direction of time movement by using a direction in which the machine entropy changes.

9. The method for implementing time cognition according to claim 8, wherein each value of the machine entropy represents a moment on a timeline.

10. The method for implementing time cognition according to claim 8 or 9, wherein a direction in which the machine entropy increases represents a direction in which time moves forward.

11. The method for implementing time cognition according to any one of claims 8 to 10, wherein a current value of the machine entropy represents "present", based on the current value, a direction in which the machine entropy decreases represents "past", and a direction in which the machine entropy increases represents "future".

12. The method for implementing time cognition according to any one of claims 8 to 11, wherein the electrical signals comprise all electrical signals in the electronic system, and the machine entropy is a sum of change times of characteristic parameters of the all electrical signals.

13. The method for implementing time cognition according to any one of claims 8 to 11, wherein the electrical signals comprise electrical signals, corresponding to a proportion that is not less than a certain predetermined proportion, in the electronic system.

14. The method for implementing time cognition according to any one of claims 8 to 13, wherein the machine entropy is directly proportional to a total amount of information processed by the electronic system, to a wear degree of the electronic system, and to a total amount of energy consumed by the electronic system.

15. The method for implementing time cognition according to any one of claims 8 to 14, wherein for each of the electrical signals, a case where a change value of an amplitude of a characteristic parameter of each of the electrical signals meets a predetermined threshold range indicates that a change in the characteristic parameter has occurred one time.

16. The method for implementing time cognition according to claim 15, wherein for each of the electrical signals, a case where the amplitude of the characteristic parameter of each of the electrical signals rises from a first threshold to a second threshold or drops from the second threshold to the first threshold indicates that the change in the characteristic parameter has occurred one time.

17. The method for implementing time cognition according to any one of claims 8 to 16, wherein the characteristic parameters of the electrical signals comprise at least one of voltages of the electrical signals or currents of the electrical signals.

18. A calculation circuit of a machine entropy, comprising:

   a monitoring sub-circuit, configured to monitor electrical signals in an electronic system; and
   a calculation sub-circuit, configured to calculate the machine entropy, the machine entropy being a sum of change times of characteristic parameters of the electrical signals.

19. The calculation circuit of the machine entropy according to claim 18, wherein the electrical signals comprise all electrical signals in the electronic system, and the machine entropy is a sum of change times of characteristic parameters of the all electrical signals.

20. The calculation circuit of the machine entropy according to claim 18, wherein the electrical signals comprise electrical signals, corresponding to a proportion that is not less than a certain predetermined proportion, in the electronic system.

21. The calculation circuit of the machine entropy according to any one of claims 18 to 20, wherein the machine entropy is directly proportional to a total amount of information processed by the electronic system, to a wear degree of the electronic system, and to a total amount of energy consumed by the electronic system.

22. The calculation circuit of the machine entropy according to any one of claims 18 to 21, wherein for each of the electrical signals, a case where a change value of an amplitude of a characteristic parameter of each of the electrical signals meets a predetermined threshold range indicates that a change in the characteristic parameter has occurred one time.

23. The calculation circuit of the machine entropy according to claim 22, wherein a case where the amplitude of the characteristic parameter rises from a first threshold to a second threshold or drops from the second threshold to the first threshold indicates that the change in the characteristic parameter has occurred one time.

24. An electronic system for implementing time cognition, comprising:

   the calculation circuit of the machine entropy according to any one of claims 18 to 23; and
   a time indicating circuit, configured to indicate a direction of time movement by using a direction in which the machine entropy changes.

25. The electronic system according to claim 24, wherein each value of the machine entropy represents a moment on a timeline.

26. The electronic system according to claim 24 or 25, wherein a direction in which the machine entropy increases represents a direction in which time moves forward.

27. The electronic system according to any one of claims 24 to 26, further comprising:

   a space cognition circuit, configured to achieve space cognition of the electronic system;
   a clock generation circuit, configured to generate a clock signal to establish an operating order of the electronic system; and
   a timing circuit, configured to measure or control a length of an event occurring within the electronic system, wherein the length is calibrated by using the clock signal.

100

S102 | monitoring electrical signals of the electronic system

S104 | calculating the machine entropy, the machine entropy being a sum of change times of characteristic parameters of the electrical signals

FIG. 1

200

S202 | calculating a machine entropy in the electronic system

S204 | indicating a direction of time movement by using a direction in which the machine entropy changes

FIG. 2

total amount of
information generated
(continuously increase)

direction of time

value of entropy

energy
consumption
(irreversibility)

FIG. 3A

total amount of
information processed
(continuously increase)

direction of time

value of machine
entropy

value

current

electricity
consumption
( irreversibility)

FIG. 3B

calculation circuit of
machine entropy
400

| monitoring sub-circuit 402 | calculation sub-circuit 404 |

FIG. 4

electronic system
500

calculation circuit of
machine entropy
400

monitoring sub-
circuit 402

calculation sub-
circuit 404

time indicating circuit
502

FIG. 5A

electronic system
500

calculation circuit of
machine entropy
400

monitoring sub-
circuit 402

calculation sub-
circuit 404

time indicating
circuit 502

space cognition
circuit 504

clock generation
circuit 506

timing circuit 508

FIG. 5B

## INTERNATIONAL SEARCH REPORT

| International application No. |
|---|
| **PCT/CN2018/115446** |

### A. CLASSIFICATION OF SUBJECT MATTER

G06F 17/50(2006.01)i

According to International Patent Classification (IPC) or to both national classification and IPC

### B. FIELDS SEARCHED

Minimum documentation searched (classification system followed by classification symbols)

G06F

Documentation searched other than minimum documentation to the extent that such documents are included in the fields searched

Electronic data base consulted during the international search (name of data base and, where practicable, search terms used)

CNPAT, WPI, EPODOC, CNKI, IEEE, GOOGLE: 时间, 计时, 计数, 电压, 电流, 信号, 变化, 改变, 次数, time, clock, timer, count, voltage, current, signal, change, vary, times

### C. DOCUMENTS CONSIDERED TO BE RELEVANT

| Category* | Citation of document, with indication, where appropriate, of the relevant passages | Relevant to claim No. |
|---|---|---|
| X | CN 102487277 A (NUVOTON TECHNOLOGY CORPORATION) 06 June 2012 (2012-06-06)<br>description, paragraphs [0024]-[0032] | 1-27 |
| A | CN 202854868 U (SHANGHAI SHENGJUN ELECTRIC MANUFACTURING CO., LTD.) 03 April 2013 (2013-04-03)<br>entire document | 1-27 |
| A | CN 104426684 A (PHICOMM (SHANGHAI) CO., LTD.) 18 March 2015 (2015-03-18)<br>entire document | 1-27 |
| A | CN 106532906 A (FANUC CORPORATION) 22 March 2017 (2017-03-22)<br>entire document | 1-27 |
| A | US 5363904 A (PIERRET, PETER G. ET AL.) 15 November 1994 (1994-11-15)<br>entire document | 1-27 |

☐ Further documents are listed in the continuation of Box C.    ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **04 January 2019** | **15 February 2019** |

| Name and mailing address of the ISA/CN | Authorized officer |
|---|---|
| **National Intellectual Property Administration, PRC (ISA/ CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**
Information on patent family members

International application No.

**PCT/CN2018/115446**

| Patent document cited in search report | | | Publication date (day/month/year) | Patent family member(s) | | | Publication date (day/month/year) |
|---|---|---|---|---|---|---|---|
| CN | 102487277 | A | 06 June 2012 | None | | | |
| CN | 202854868 | U | 03 April 2013 | None | | | |
| CN | 104426684 | A | 18 March 2015 | None | | | |
| CN | 106532906 | A | 22 March 2017 | US | 2017077731 | A1 | 16 March 2017 |
| | | | | JP | 2017053754 | A | 16 March 2017 |
| | | | | DE | 102016010814 | A1 | 16 March 2017 |
| US | 5363904 | A | 15 November 1994 | CA | 2126925 | A1 | 31 January 1995 |
| | | | | SG | 47660 | A1 | 17 April 1998 |
| | | | | ES | 2117760 | T3 | 16 August 1998 |
| | | | | BR | 9402984 | A | 11 April 1995 |
| | | | | KR | 0138035 | B1 | 15 June 1998 |
| | | | | EP | 0636961 | A1 | 01 February 1995 |
| | | | | HK | 1011510 | A1 | 09 July 1999 |
| | | | | MX | 187180 | B | 28 November 1997 |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• CN 201810045295